Europäisches Patentamt

European Patent Office

Office européen des brevets

(19)

(11) Numéro de publication: **0 145 599**
**B1**

(12) **FASCICULE DE BREVET EUROPEEN**

(45) Date de publication du fascicule du brevet: **06.04.88**

(21) Numéro de dépôt: **84402530.4**

(22) Date de dépôt: **07.12.84**

(51) Int. Cl.⁴: **H 01 L 23/14,** H 01 L 23/48, C 04 B 35/10

(54) Substrat d'interconnexion en alumine pour composant électronique, et procédé pour sa fabrication.

(30) Priorité: **08.12.83 FR 8319689**

(43) Date de publication de la demande:
**19.06.85 Bulletin 85/25**

(45) Mention de la délivrance du brevet:
**06.04.88 Bulletin 88/14**

(84) Etats contractants désignés:
**DE FR GB IT NL**

(56) Documents cités:
**EP-A-0 027 017**
**EP-A-0 027 825**
**EP-A-0 045 877**
**US-A-4 340 635**

**CHEMICAL ABSTRACTS, vol. 97, 1982, page 672, no. 137113m, Columbus, Ohio, US; C. DRAGOMIR et al.: "Alumina powders for electronic use"**
**Idem**

(73) Titulaire: **EUROFARAD EFD**
**93 rue Oberkampf**
**F-75011 Paris (FR)**

(84) **FR**

(73) Titulaire: **XERAM**
**Tour Manhattan 6, place de l'Iris La Défense**
**F-92400 Courbevoie (FR)**

(84) **DE GB IT NL**

(72) Inventeur: **Dubuisson, Jacques**
**22, Avenue Emile Zola**
**F-75015 Paris (FR)**
Inventeur: **le Gal, Pascal**
**4, rue de Paris**
**F-77450 Magny Le Hongre (FR)**
Inventeur: **Boutterin, René**
**9, rue de l'Etang Linas**
**F-91310 Montlhery (FR)**

(74) Mandataire: **Martin, Jean-Jacques et al**
**Cabinet REGIMBEAU 26, Avenue Kléber**
**F-75116 Paris (FR)**

Courier Press, Leamington Spa, England.

EP 0 145 599 B1

## Description

La présente invention concerne, de façon générale, un substrat pour composants électroniques; il peut s'agir de supporter un composant unitaire (par exemple une puce de circuit intégré), ou bien un ensemble de composants discrets, actifs ou passifs, réunis sur un même substrat (carte de circuit ou circuit hybride).

Ce substrat est du type formé d'un empilement fritté de feuilles de matériau diélectrique dont certaines au moins portent des motifs conducteurs, avec en surface des émergences conductrices (pistes ou simples collerettes) qui seront par la suite reliées aux bornes du composant; il est également prévu, dans ce substrat, au moins une couche interne pourvue de pistes conductrices assurant l'interconnexion de couche à couche (entre couches internes ou entre une couche interne et la couche supérieure) et avec les émergences, selon un schéma préétabli.

On connaît les propriétés avantageuses de l'alumine pour la réalisation des substrats pour composants électroniques, par rapport aux céramiques classiques: excellentes propriétés diélectriques (notamment la faible augmentation de la tangente de l'angle de pertes en fonction de la fréquence), conductibilité thermique élevée (évitant l'apparition de points chauds et facilitant le drainage thermique pour les composante de puissance ou à très haut degré d'intégration), bonnes propriétés mécaniques, bon état de surface permettant le report direct de conducteurs de grande finesse, par gravure photochimique notamment.

L'excellent comportement en fréquence permet tout particulièrement l'utilisation de ces substrats dans le domaine des hyperfréquences ou des circuits logiques à très grande rapidité (temps de commutation de l'ordre de 100 ps), où l'emploi de céramiques classiques ne peut être envisagé.

Ces diverses propriétés avantageuses ne sont cependant pleinement obtenues que pour une composition d'alumine du type "ultra-pure", c'est-à-dire contenant au moins 99% d'$Al_2O_3$, de préférence 99,9% d'$Al_2O_3$; une telle composition nécessite une cuisson à haute température, de l'ordre de 1600°C à 1800°C, cette température étant d'autant plus élevée que l'alumine est plus pure.

Les compositions couramment utilisées pour la réalisation de substrats en alumine comprennent généralement 80 à 96% d'$Al_2O_3$. Les produits obtenus présentent environ 80% des propriétés mécaniques, et 60 à 70% des propriétés thermiques de l'alumine ultrapure. Par contre, la tangente de l'angle de pertes augmente ou varie anormalement en fonction de la fréquence, ce qui interdit leur emploi pour des applications hyperfréquences. En outre, la température de cuisson reste toujours de l'ordre de 1600°C.

Par exemple, le US—A—4.340.635 décrit un substrat de structure composite formé d'une base d'alumine à 96,6% revêtue d'une couche superficielle d'alumine à 99,4% (l'objet de ce brevet est d'obtenir avec une alumine à 96,6% seulement l'état de surface d'une alumine ultra-pure): la température de cuisson y est de 1575—1675°C, préférentiellement 1640°C.

Lorsque l'on souhaite réaliser un substrat d'interconnexion (c'est-à-dire comportant ab initio des métallisations enterrées, et non reportées ultérieurement sur l'alumine après cuisson), cette gamme de températures impose l'emploi, pour la réalisation de ces pistes enterrées d'interconnexion, de métaux réfractaires tels que le molybdène ou le tungstène ou un alliage de ces métaux (les métaux ou alliages non oxydables couramment utilisés ont tous des températures de fusion comprises entre 960°C (argent) et 1550°C (palladium), inférieures aux températures maximales requises pour la cuisson, de l'ordre de 1600°C).

Un premier inconvénient de cette technique résulte du caractère oxydable de ces métaux: la cuisson du substrat doit donc être opérée en atmosphère réductrice, dans un four à atmosphère contrôlée (par exemple en atmosphère d'hydrogène). En outre, le substrat ainsi obtenu ne peut supporter une recuisson en atmosphère oxydante (par exemple à l'air ambiant), notamment pour une opération de report ultérieur de pistes conductrices supplémentaires en surface.

Un second inconvénient provient de la formation, lors du cofrittage, d'un oxyde mixte de diffusion à l'interface métal-alumine; cette particularité permet certes d'augmenter l'adhérence des pistes conductrices en surface du substrat, mais présente l'inconvénient, pour les métallisations enterrées, de former des conducteurs de géométrie médiocre, du fait des zones de diffusion. Il n'est donc pas possible de réaliser des pistes enterrées de grande finesse pour des interconnexions à haute densité, ni d'éliminer le risque d'apparition de coupures (ou de court-circuits entre conducteurs trop proches) lors du cofrittage.

On connaît par ailleurs une seconde technique de fabrication de substrats d'interconnexion, avec cuisson en atmosphère oxydante (air ambient par exemple) et à plus basse température, de l'ordre de 900 à 1270°C. Pour cela, la composition est modifiée par addition à l'alumine de silice et d'oxydes de métaux alcalins ou alcalino-terreux (magnésie, chaux, soude, potasse) de manière à se rapprocher d'une porcelaine ou d'un verre céramisé.

Il devient possible d'utiliser des métaux non oxydables et non fusibles aux températures maximales atteintes lors de la cuisson, tels que le palladium, l'or, l'argent ou des alliages de ces métaux. Le EP—A—0.045.877 décrit par exemple un tel type de substrat.

Par contre, les propriétés des substrats obtenus sont sans commune mesure avec celles des substrats en alumine pure ou ultra-pure; la mobilité des additifs alcalins accroît la conductibilité électrique du diélectrique, qui devient en outre sensible à la température; la forte concentration en silice fait perdre les propriétés thermiques et mécaniques exceptionnelles de l'alumine, pour se rapprocher de celles du verre (mauvaise conduction thermique, fragilité). En tout état de cause, une application hyperfréquence n'est pas envisageable.

Une troisième technique, dérivée de la précédente, consiste, après une première étape de cuisson d'une base en alumine pure ou ultra-pure, à sérigraphier en surface des conducteurs, à recouvrir ces conducteurs d'une couche de verre céramisé, pous à cuire l'ensemble à basse température (850—900°); les opérations de sérigraphie-couverture-cuisson sont alors répétées autant de fois que l'on souhaite de niveaux d'interconnexion enterrée.

Les possibilités de cette technique sont cependant limitées à un faible nombre de niveaux d'interconnexion, du fait de la diffusion cumulative du métal lors des cuissons successives. En outre, le fait que les couches intercalaires ne sont pas réalisées en alumine limite les performances électriques et thermiques de l'ensemble obtenu.

L'invention vise à éliminer ces inconvénients et à s'affranchir des solutions de compromis de la technique antérieure, en proposant un substrat d'interconnexion en alumine à hautes performances bien que réalisé selon une technologie simplifiée, ainsi qu'un procédé pour sa fabrication.

Plus précisément, l'un des buts de l'invention est d'obtenir un substrat d'interconnexion réunissant toutes les propriétés jusqu'à présent exclusivement propres à l'alumine ultra-pure, à savoir: les excellentes propriétés diélectriques requises par les applications hyperfréquences, la conductibilité thermique élevée permettant de drainer efficacement une dissipation thermique élevée localisée sur une faible surface, l'obtention directe d'un bon état de surface, la faible porosité, la robustesse mécanique, la possibilité de réaliser des couches diélectriques de faible épaisseur, d'en multiplier le nombre ou d'en varier les épaisseurs, et l'homogénéité du retrait à la cuisson.

Un autre but de l'invention est de permettre la réalisation de substrats d'interconnexion en atmosphère oxydante avec une température maximale de cuisson abaissée jusqu'à une valeur de l'ordre de 1400°C, permettant en particulier l'emploi de métaux tels le palladium ou ses alliages—qui ne diffusent pas ou peu dans l'alumine—en remplacement des métaux réfractaires oxydables tels que le molybdène ou le tungstène jusqu'à présent seuls convenables.

Un autre but de l'invention est de réaliser un tel substrat avec une opération unique de cuisson de toutes les couches du produit, éliminant les défauts rencontrés avec les procédés à cuissons successives.

Un autre but de l'invention est de réaliser un substrat d'interconnexion dans lequel les trous métallisés permettant l'interconnexion de couche à couche, des couches à la surface, et d'une face à l'autre du substrat (et ci-après désignés "vias") présentent une géométrie cylindrique excellente, assurant un faible taux de rebut après compression tout comme après frittage, et dans lequel les métallisations des vias, ainsi que les collerettes formées au débouché de ces vias, présentent une adhérence au substrat particulièrement élevée.

L'emploi de métaux tels que le palladium et ses alliages améliore certes, du fait de l'absence de diffusion, la qualité géométrique des conducteurs, mais a pour inconvénient corrélatif le faible accrochage du métal à l'alumine, à la différence par exemple du tungstène ou du molybdène qui forment des composés intermédiaires dans la zone de diffusion à l'interface métal-alumine (voir à cet égard Otsuka et al. "Interfacial bond strength in alumina ceramics metallized and cofired with tungsten" in Ceramic Bulletin Vol. 60, No. 5, 1981). On verra que, par l'un de ses aspects, l'invention permet d'échapper à ce dilemme.

A cet effet, l'invention propose un substrat d'interconnexion pour composants électroniques, formé d'un empilement fritté de feuilles de matériau diélectrique dont certaines au moins portent des motifs conducteurs, ce substrat présentant des émergences conductrices pour assurer la liaison aux bornes du (des) composant(s), avec au moins une couche interne pourvue de pistes conductrices assurant l'interconnexion de couche à couche et avec ces émergences selon un schéma préétabli. Selon l'invention, la composition du matériau diélectrique comprend 92 à 98% d'$Al_2O_3$ et un agent fondant diélectrique à base de titanate de magnésie, dont la composition est comprise entre ($TiO_2$, 0,5 MgO) et ($TiO_2$, 6 MgO), de manière à abaisser la température maximale de frittage à une valeur comprise entre 1350 et 1450°C cette composition etant substantiellement depourvue de silice, de composé halogené ou alcalin et de résidus carbonés et les motifs conducteurs sont réalisés en un métal qui, à la température maximale atteinte au cours de la cuisson, ne soit ni oxydable ni fusible, ou un alliage de tels métaux.

(Dans la suite, par "haute température", on entendra la température maximale nécessaire au frittage de la composition envisagée).

L'abaissement de la température maximale de cuisson à des valeurs de 1350—1430°C (généralement 1400—1410°C) résulte de l'addition à de l'$Al_2O_3$ ultra-pure (99,9%) du titanate de magnésie, qui est un agent déjà connu—en tant que tel—pour ses propriétés diélectriques avantageuses, en particulier dans le domaine des hyperfréquences.

L'invention est basée sur la constantation des propriétés d'agent fondant de ce composé, lorsqu'il est combiné à l'alumine. De plus et surtout, cette combinaison conserve l'intégralité des propriétés, diélectriques, thermiques, mécaniques, ... de l'alumine ultra-pure, comme on le constatera à l'énoncé des propriétés d'un exemple illustratif de composition donné par la suite.

De préférence, la proportion d'$Al_2O_3$ est comprise entre 95 et 97%.

De préférence également, la composition de l'agent fondant est ($TiO_2$, MgO).

On notera que, ici comme dans la suite, toutes les proportions des différents constituants sont donnés en poids et pour des constituants anhydres.

Il est essentiel de noter qu'un certain nombre de précautions doivent être prises tout au long du procédé de fabrication, tant en ce qui concerne le choix des matériaux que la conduite du procédé.

Les exigences suivantes sont considérées comme nécessaires à l'obtention, pour le produit final, de toutes les caractéristiques qui étaient jusqu'à présent considérées comme exclusivement propres à l'alumine ultra-pure:

. granulométrie de la composition à l'état de matière première comprise entre 0,2 et 0,4 µm.

. absence de composés halogénés ou alcalins et de résidus carbonés pour tous les agents utilisés, tant les matières premières que les matériaux évanescents (c'est-à-dire les matériaux, nécessaires à la préparation et à la mise en forme des feuilles de diélectrique, qui disparaissent lors du frittage).

De tels composés sont souvent présents dans les produits constitutifs des alumines classiques (par exemple les argiles) ou rajoutés comme défocculants (pour la préparation de la barbotine), liants organiques ou agents fondants. Il convient de les proscrire pour la réalisation du substrat selon l'invention.

. bien qu'il soit plus facile de les éliminer qu'un liant, il apparaît souhaitable d'exclure également les solvants halogénés (par exemple trichloréthylène).

. régime thermique très précis lors du frittage; une homogénéité de température à ±1°C sur toute l'étendue de la plaque apparaît souhaitable.

En ce qui concerne les motifs conducteurs, ceux-ci sont réalisés avantageusement en palladium ou en alliage argent-palladium.

La température de fusion du palladium pur est en effet de 1552°C, dont parfaitement compatible avec une cuisson de l'alumine à une température de 1400°C environ.

Dans le cas d'un alliage argent-palladium, on choisit les proportions respectives des deux métaux de sorte que la température de fusion de l'alliage reste inférieure à la température maximale atteinte au cours de la cuisson, par exemple un alliage à au moins 60% de palladium pour une température de cuisson de 1400° (ces valeurs sont déterminées à partir du diagramme binaire de l'alliage Ag-Pd). Ceci permet de bénéficier des bonnes propriétés conductrices des alliages argent-palladium.

Le fait que le palladium passe par un état oxydable entre 384 et 920°C n'est pas gênant pour la mise en oeuvre de l'invention car, lors de la descente en température après cuisson, les métallisations enterrées sont scellées par le diélectrique fritté, de sorte que le palladium demeure sous forme métallique et toute oxydation future est empêchée, même lors d'une recuisson ultérieure. Quant aux parties émergentes, il se forme sur le métal massif une couche pelliculaire protectrice d'oxyde non gênante pour les opérations ultérieures de soudure ou de brasure.

Avantageusement, les interconnexions de couche à couche et avec les émergences sont réalisées au moyen de vias dont le revêtement métallisé est à base d'un métal également non oxydable et non fusible à haute température ou d'un alliage de tels métaux.

Dans un mode de mise en oeuvre avantageux de l'invention, le revêtement des vias est réalisé à partir d'une encre de métallisation chargée en $Al_2O_3$, les motifs conducteurs étant réalisés à partir d'une entre non chargée en $Al_2O_3$. De préférence, la composition de l'encre chargée en $Al_2O_3$ comprend, dans un véhicule organique évanescent, 60 à 80% de métal libre et 2 à 5% d'$Al_2O_3$.

Avantageusement, la composition de l'encre chargée en $Al_2O_3$ comprend un agent fondant à base de silice et de magnésie apte à abaisser la température de cuisson de cette encre à une valeur égale ou légèrement inférieure à la température de cuisson de l'alumine du substrat. De préférence, les proportions relatives de l'agent fondant et de l'$Al_2O_3$ sont environ ($Al_2O_3$, $4SiO_2$, $3MgO$).

Comme il a été indiqué plus haut, le palladium (ou l'alliage argent-palladium) est un métal qui ne diffuse pas dans la céramique; au contraire, on observe même un retrait au frittage, d'autant plus important que la concentration en palladium de l'encre est forte (l'encre utilisée pour la réalisation des pistes enterrées d'interconnexion contient généralement 40 à 60% de palladium, le restant étant constitué de solvants et liants organiques évanescents).

L'addition d'$Al_2O_3$ à l'encre utilisée pour la métallisation des vias (qui n'est alors plus la même que celle utilisée pour les conducteurs enterrés) permet de créer au frittage un "squelette" de céramique sur la surface intérieure du trou, qui gêne le retrait du palladium (retrait supérieur à celui de la céramique) et permet d'obtenir une excellente géométrie du via, qui conserve sa forme cylindrique au lieu de prendre une forme "en tonneau".

On observe en outre la formation d'une zone de transition assurant une forte adhérence du métal au substrat.

On évite enfin les phénomènes de fluage lors de la compression (trous qui se referment sur eux-mêmes) et de formation de criques lors du frittage.

La proportion de vias correctement réalisés est proche de 100%, contre environ 10% en cas d'utilisation d'une encre identique à celle utilisée pour les conducteurs enterrés, c'est-à-dire non chargée en alumine.

En revanche, les conducteurs enterrés et les conducteurs en surface du substrat sont réalisés à partir d'une encre non chargée en $Al_2O_3$, ce qui leur permet de conserver une bonne géométrie du fait de l'absence de diffusion du palladium.

Avantageusement, on utilise la même encre, chargée en $Al_2O_3$, pour la réalisation de collerettes au débouché des vias. Ces collerettes vont retenir les conducteurs en surface du substrat, qui ont une faible adhérence à ce dernier.

L'invention ainsi envisagée concerne un substrat d'interconnexion réalisé à la manière des circuits imprimés multicouches, c'est-à-dire avec une surface supérieure plane portant éventuellement des pistes conductrices superficielles.

Sur l'une ou l'autre face (ou les deux), ce substrat laisse apparaître des plots métalliques correspondant à des terminaisons de composants (condensateurs, inductances intégrées) isolés ou interconnectés, ou aux bornes d'un réseau d'interconnexions enterrées, d'un plan de masse, .... Le report de composants discrets reliés à ces plots permettra l'obtention d'un circut hybride, technologie classique en elle-même.

Mais on peut également envisager que ce substrat forme une base omnibus que l'utilisateur pourra reprendre et personnaliser en fonction de ses besoins propres par report d'un interconnexion de surface (dépôt par sérigraphie de conducteurs ou de résistances). On est alors en présence d'une technique comparable à celle des circuits prédiffusés, en matière de composants actifs.

Cette caractéristique particulièrement intéressante résulte de la possibilité, avec le substrat de l'invention, de procéder à une recuisson en atmosphère oxydante, opération typique de la sérigraphie: on y utilise classiquement des encres à base de ruthénium ou palladium, nécessitant une cuisson à environ 750—950°C.

L'invention concerne également les substrats connus dans la technique sous le nom "chip carrier" (supports de puce), c'est-à-dire dont la surface supérieure est étagée sur au moins deux niveaux. Le plus souvent, ces substrats possèdent trois niveaux: l'étage inférieur, central, sert de support à la puce, généralement une puce de circuit intégré à haute échelle d'intégration; un étage intermédiaire périphérique (quelquefois la périphérie de l'étage inférieur lui-même) est pourvu d'émergences à relier aux bornes de la puce, tandis que l'étage supérieur forme entretoise périphérique pour sceller un couvercle qui enfermera complètement le composant, en dissimulant en outre la surface supérieure, étagée, du substrat.

Les liaisons vers l'extérieur sont alors réalisées par des émergences latérales du substrat, ou encore par des trous métallisés débouchant à la surface de l'étage supérieur.

Dans tous les cas, outre les interconnexions in situ, les excellentes propriétés diélectriques du substrat permettent de prévoir des motifs conducteurs internes faisant fonction de plan de masse, d'armatures pour des condensateurs de découplage ou de filtrage, de lignes d'alimentation, ou encore d'inductances intégrées, voire de drains thermiques. Ainsi, seuls les éléments résistifs auront besoin d'être reportés en surface.

L'invention concerne également un procédé de fabrication de tels substrats, qui prévoit les étapes de:

. perçage en cru des trous par un foret entraîné à grande vitesse, lorsque les feuilles ont une épaisseur supérieure à environ 250 μm, ou par un système poinçon-matrice lorsque les épaisseurs sont inférieures,

. remplissage des trous par une encre de métallisation à base de palladium ou d'argent-palladium chargée en $Al_2O_3$, ou une céramique alumineuse,

. sérigraphie des feuilles individuelles d'alumine, avec dépôt d'une autre entre de métallisation, non chargée en $Al_2O_3$,

. empilement des feuilles individuelles,

. agglomération du bloc à chaud et sous pression,

. cofrittage par cuisson à haute température en atmosphère oxydante, et après évacuation lente et programmée des liants organiques.

Avantageusement, lors de l'étape de remplissage des trous, on sérigraphie également des collerettes au débouché de ces trous, avec dépôt de la seconde encre de métallisation, ainsi que des conducteurs en surface du substrat, avec dépôt de la première encre de métallisation.

De préférence, dans ce cas le remplissage des trous se fait par sérigraphie avec aspiration des feuilles sur un socle, et interposition d'une couche de papier poreux entre la feuille intérieure et le socle-support de la machine; si nécessaire, cette opération peut être effectuée recto-verso.

D'autres caractéristiques et avantages de l'invention apparaîtront à la lecture de la description détaillée ci-dessous, faite en référence aux dessins annexés sur lesquels:

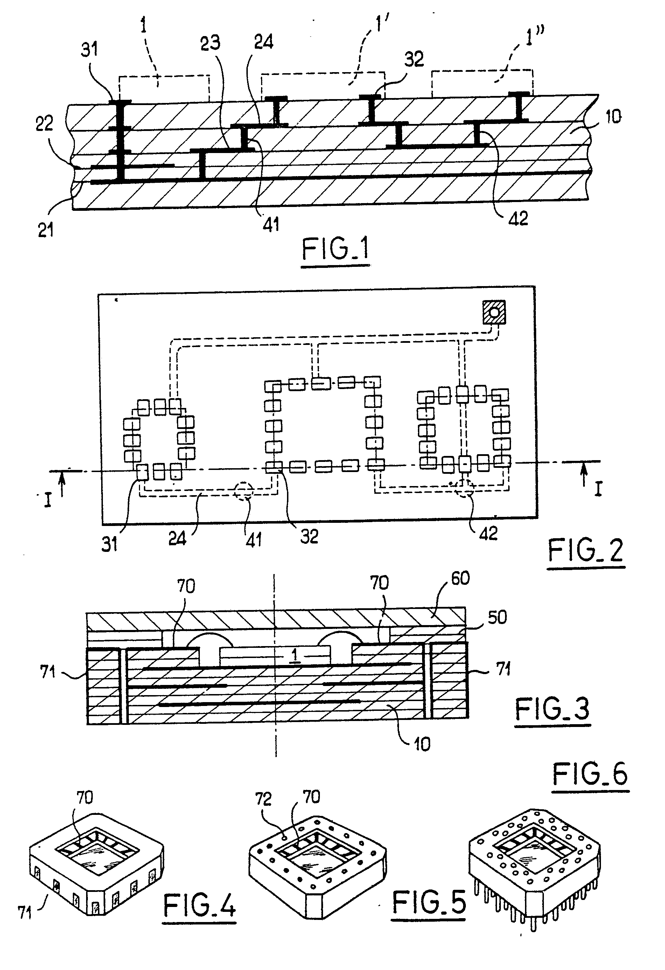

. la figure 1 est une vue en coupe d'un substrat plan selon l'invention, selon la ligne I—I de la figure 2,

. la figure 2 est une vue en plan de ce même substrat,

. la figure 3 est une vue en coupe, homologue de la figure 1, pour un support de puce à plusieurs niveaux,

. la figure 4 est une vue perspective du support de la figure 3 pris isolément (sans la puce ni le couvercle),

. les figures 5 et 6 sont des variantes de la figure 4, dans le cas où les connexions extérieures sont réalisées au moyen de trous métallisés et non d'émergences latérales.

Sur la figure 1, on a représenté en coupe un substrat 10 (vu en plan figure 2) destiné à supporter un composant électronique 1. Bien qu'on ait représenté un substrat pour un composant unique, il est possible d'envisager des substrats de plus grandes dimensions pour supporter et interconnecter un ensemble de plusieurs composants actifs et passifs placés en surface de ce substrat.

Ce substrat 10 est pourvu d'émergences conductrices telles que 31 et 32 destinées à être reliées aux bornes du composant. Ces émergences peuvent être de simples collerettes auxquelles seront soudés des fils de connexion; elles peuvent être également, comme représenté, des pistes conductrices s'étendant en surface du substrat et reliées soit à des organes extérieures, soit à d'autres composants disposés sur le même substrat.

Le substrat 10 est formé d'une pluralité de couches supportant différents dessins conducteurs référencés 21 à 24 et interconnectés entre eux: on a par exemple illustré une électrode 21 formant plan de masse, une armature 22 de condensateur formant, avec le plan de masse 21, un élément de découplage d'alimentation, ainsi que des liaisons 23 et 24 permettant l'interconnexion entre différentes bornes du même composant ou entre des bornes de plusieurs composants disposés sur le même substrat (le dessin de ces interconnexions est par exemple illustré figure 2 en tiretés).

Les interconnexions entre les différentes couches et avec les émergences en surface du substrat sont réalisées de préférence au moyen de trous métallisés tels que 41 et 42, traversant les différentes couches à interconnecter (ces trous ont été représentés traversant le substrat de part en part, mais ils peuvent également être borgnes).

Le procédé de fabrication d'un tel substrat est le suivant:

. on encolle tout d'abord sur un cadre les feuilles individuelles d'alumine, ou bien des ensembles de plusieurs feuilles (par exemple 4 à 6) déjà comprimées et qui formeront les couches du substrat.

. on procède ensuite au perçage en cru des trous destinés à assurer les interconnexions. Ce perçage est réalisé de préférence au moyen d'un foret au carbure entraîné à grande vitesse (plus de 30.000 t/mn) et guidé par une machine de reconnaissance de forme pilotée par ordinateur.

. on remplit les trous avec une encre de métallisation spécifique. Cette opération permet le remplissage des vias lorsque les épaisseurs des couches élémentaires sont inférieures à 250 µm.

L'encre utilisée, différente de celles utilisées pour la sérigraphie des motifs conducteurs (internes ou en surface) comprend par exemple 60 à 80% de palladium et 2 à 5% d'$Al_2O_3$ ultrafine, ainsi que des agents fondants, par exemple 3 parts de MgO et 4 parts de $SiO_2$ pour 1 part d'$Al_2O_3$.

. les motifs conducteurs sont ensuite sérigraphiés sur chacune de ces feuilles, de manière classique, au moyen d'une autre encre comprenant par exemple 40 à 60% de palladium avec des solvants et des liants organiques évanescents, non chargée en $Al_2O_3$.

. les différentes feuilles ainsi préparées sont ensuite superposées pour former l'empilement.

. les trous débouchant de part et d'autre, de fort diamètre et dans des feuilles de forte épaisseur, sont éventuellement métallisés une nouvelle fois. Pour cela, on dépose une goutte d'encre de métallisation, qui coule par gravité dans le trou; on peut également effectuer ce dépôt de l'encre au moyen d'un goupillon introduit dans le trou. L'encre utilisée est une encre chargée en alumine, du même type que celle utilisée pour la métallisation des trous.

Avantageusement, les feuilles sont maintenues sur un socle par aspiration sous vide, de manière classique, et on interpose une feuille de papier poreux (tel qu'un papier filtre) pour que, au moment du dépôt de l'encre de métallisation, celle-ci se répartisse uniformément à l'intérieur du trou du fait de l'aspiration; le papier poreux permet en outre de recueillir le surplus d'encre, ce qui évite de souiller la face inférieure de l'empilement.

. l'empilement est ensuite aggloméré à chaud et sous pression en un bloc homogène.

. on procède ensuite à la cuisson de l'ensemble. Cette cuisson est une cuisson à haute température (1400°) sous atmosphère oxydante; elle est par exemple réalisée dans un four à passage ou un four fixe, pendant une durée totale de dix heures par exemple. Au préalable, les liants et solvants organiques ont été évacués par une traitement sous vide suivi d'une montée programmée, très lente, en température, en atmosphère oxydante, en tenant compte des caractéristiques intrinsèques des produits organiques. Cette opération dont la durée peut atteindre une semaine est fondamentale pour l'obtention d'un substrat parfaitement homogène dans ses caractéristiques.

. éventuellement, on reporte en surface des pistes conductrices par sérigraphie de conducteurs à base d'argent, d'argent-palladium ou d'or avec un fondant permettant la liaison avec le substrat (méthode habituelle des circuits hybrides). On peut prévoir également des résitances ou même des condensateurs.

Un tel substrate d'interconnexion présente d'excellentes propriétés diélectriques et mécaniques. Par exemple, pour une composition comprenant 96% d'alumine et un élément fondant diélectrique à base de titanate de magnésie de formule ($TiO_2$, MgO), on obtient les caractéristiques suivantes:

—caractéristique diélectrique relative par rapport à l'air: 9,1 environ,

—rigidité diélectrique: 70 V/µm environ,

—tangente de l'angle de pertes inférieure à $1.10^{-4}$ à 1 MHz,

—résistance d'isolement supérieure à 1000 GΩ pour une épaisseur de 50 µm, pratiquement invariable avec la température, tout au moins jusqu'à 200°C,

—homogénéité du retrait assurée à environ 0,1% près, pour un retrait de 25% et une surface de 70×70 mm. Cette valeur correspond à une amélioration d'un ordre de grandeur environ par rapport aux autres céramiques (homogénéité de l'ordre de 1%).

—excellente rugosité obtenue directement par cuisson, comparable à celle d'une alumine à 99,9%. Cette caractéristique permet une finesse de trait compatible avec une gravure par procédé photolithographique.

—porosité moyenne inférieure à 1 µm.

Du point de vue thermique, on notera que la conductivité thermique de l'alumine est grandement améliorée par la présence des pistes conductrices, qui jouent le rôle de drains thermiques.

Les motifs conducteurs réalisés habituellement offrent une résistance électrique de l'ordre de 0,01 Ω par carré. Cette valeur peut être abaissée en augmentant l'épaisseur de la couche métallique ou encore en prévoyant plusieurs conducteurs connectés en parallèle et répartis sur plusieurs couches du substrat.

On notera enfin la possibilité de réaliser des couches de diélectrique minces (25 μm, contre 50 μm minimum pour une céramique classique), et de varier les épaisseurs de ces couches. On peut également prévoir un très grand nombre de couches (15 à 20 sans difficulté) assurant un très grand nombre de niveaux d'interconnexion et donc une très grande densité de conducteurs au cm²; le nombre de couches n'est pratiquement par limité, à la différence des procédés à cuissons multiples mis en oeuvre dans la technique antérieure.

L'invention s'applique particulièrement à la réalisation de supports pour puces de circuit intégré en forme de boîtiers à plusieurs niveaux, comme représenté figures 3 à 5: sur la figure 3, on peut voir, outre un substrat ayant la même structure que celui de la figure 1 (donc avec des liaisons d'interconnexion, éventuellement des éléments capacitifs, ...), un étage intermédiaire sur lequel sont reportées des connexions 70 permettant la liaison aux bornes du composant, est muni de sorties latérales 71, visibles notamment figure 4.

Un étage supplémentaire est formé par une couche 50 formant entretoise, qui permet de sceller un couvercle 60 par-dessus l'ensemble du support, pour isoler le composant et ses connexions apparentes.

La figure 5 représente une variante dans laquelle les sorties latérales 71 de la figure 4 sont remplacées par des trous métallisés 72 débouchant en surface supérieure.

Une autre variante est donnée figure 6 où les sorties sont constituées par des broches fixées mécaniquement et électriquement dans les trous précédemment mentionnés par soudure ou brasure.

La forme extérieure de tels boîtiers est généralement normalisée, par exemple selon les recommandations JEDEC.

Le procédé de fabrication de ces supports est le même que celui précédemment exposé pour la fabrication des substrats plans, avec cependant des dimensions d'ensemble plus faibles (la dimension d'un support normalisé est de 1/2'' (1,3 cm) alors que les substrats peuvent atteindre 3,5''×7'' (9×18 cm environ).

Pour réaliser les différents niveaux en surface supérieure, on se contente d'ajouter à l'empilement une ou plusieurs feuilles d'alumine crue pourvues d'une fenêtre centrale aux dimensions de la couche inférieure devant rester apparente. L'ensemble est finalement matricé au moyen d'un poinçon ayant le profil complémentaire du profil désiré.

De la même façon que dans le cas du substrat plan, il est possible de prévoir, outre les interconnexions, des éléments capacitifs de découplage et de filtrage, un plan de masse, des inductances intégrées.

## Revendications

1. Un substrat d'interconnexion pour composants électroniques, formé d'un empilement fritté de feuilles de matériau diélectrique (10) dont certaines au moins portent des motifs conducteurs (21—24), ce substrat présentant des émergences conductrices (31, 32) pour assurer la liaison aux bornes du (des) composant(s) (1), avec au moins une couche interne pourvue de pistes conductrices (24) assurant l'interconnexion de couche à couche et avec ces émergences selon un schéma préétabli,

caractérisé en ce que la composition du matériau diélectrique comprend 92 à 98% d'$Al_2O_3$ et un agent fondant diélectrique à base de titanate de magnésie, dont la composition est comprise entre ($TiO_2$, 0,5 MgO) et ($TiO_2$, 6 MgO), de manière à abaisser la température maximale de frittage à une valeur comprise entre 1350 et 1450°C, cette composition étant substantiellement dépourvue de silice, de composé halogéné ou alcalin et de résidus carbonis,

et en ce que les motifs conducteurs sont réalisés en un métal qui, à la température maximale atteinte au cours de la cuisson ne soit ni oxydable ni fusible, ou un alliage de tels métaux.

2. Un substrat selon la revendication 1, caractérisé en ce que la proportion d'$Al_2O_3$ est comprise entre 95 et 97%.

3. Un substrat selon la revendication 1, caractérisé en ce que la composition de l'agent fondant est ($TiO_2$, MgO).

4. Un substrat selon la revendication 1, caractérisé en ce que les motifs conducteurs sont réalisés en palladium ou en alliage argent-palladium.

5. Un substrat selon la revendication 1, caractérisé en ce que les interconnexions de couche à couche et avec les émergences sont réalisées au moyen de vias (41, 42) dont le revêtement métallisé est à base d'un métal également non oxydable et non fusible à haute température ou d'un alliage de tels métaux.

6. Un substrat selon la revendication 5, caractérisé en ce que le revêtement des vias est réalisé à partir d'une encre de métallisation chargée en $Al_2O_3$, les motifs conducteurs étant réalisés à partir d'une encre non chargée en $Al_2O_3$.

7. Un substrat selon la revendication 6, caractérisé en ce que la composition de l'encre chargée en $Al_2O_3$ comprend, dans un véhicule organique évanescent, 60 à 80% de métal libre et 2 à 5% d'$Al_2O_3$.

8. Un substrat selon la revendication 7, caractérisé en ce que la composition de l'encre chargée en $Al_2O_3$ comprend un agent fondant à base de silice et de magnésie apte à abaisser la température de cuisson de cette encre à une valeur égale ou légèrement inférieure à la température de cuisson de l'alumine du substrat.

9. Un substrat selon la revendication 8, caractérisé en ce que les proportions relatives de l'agent fondant et de l'Al$_2$O$_3$ sont d'environ (Al$_2$O$_3$, 4SiO$_2$, 3MgO).

10. Un substrat selon la revendication 6, caractérisé en ce que l'encre chargée en Al$_2$O$_3$ est également utilisée pour la réalisation de collerettes au débouché des vias.

11. Procédé de fabrication d'un substrat selon l'une des revendications précédentes, caractérisé en ce qu'il comprend les étapes de:

. perçage en cru des trous, par un foret entraîné à grande vitesse ou par un système poinçon-matrice,

. remplissage des trous par une encre de métallisation à base de palladium ou d'alliage argent-palladium chargée en Al$_2$O$_3$, ou une céramique alumineuse,

. sérigraphie des feuilles individuelles d'alumine, avev dépôt d'une autre encre de métallisation, non chargée en Al$_2$O$_3$,

. empilement des feuilles individuelles,

. agglomération du bloc à chaud et sous pression;

. cofrittage par cuisson à haute température en atmosphère oxydante, et après évacuation lente et programmée des liants organiques.

12. Procédé selon la revendication 11, caractérisé en ce que, lors de l'étape de remplissage des trous, on sérigraphie également des collerettes au débouché de ces trous, avec dépôt de l'encre de métallisation chargée en Al$_2$O$_3$, ainsi que des conducteurs sur au moins l'une des deux faces du substrat.

13. Procédé selon la revendication 11, caractérisé en ce que le remplissage des trous se fait avec aspiration des feuilles sur un socle, et interposition d'une couche de papier poreux entre la feuille inférieure et le socle.

14. Procédé selon la revendication 11, caractérisé en ce que l'on reporte ensuite un circuit hybride sur au moins l'une des deux faces du substrat réalisé avec ses interconnexions internes et des composants discrets internes, ce circuit hybride étant lié à l'ensemble formé par la circuiterie et les composants discrets internes par l'intermédiaire des plots apparaissant sur le substrat.

**Patentansprüche**

1. Verbindungssubstrat für elektronische Bauteile, die aus einem gesinterten Stapel von Blättern (10) aus dem elektrischen Material gebildet ist, von denen zumindest gewisse Leitungsmuster (21—24) tragen, wobei das Substrat leitende Austritte (31, 32) aufweist, um die Verbindung mit den Anschlüssen des bzw. der Bauteile (1) sicherzustellen, sowie mit wenigstens einer inneren Schicht, die mit Leiterbahnen (24) versehen ist, die die Verbindung von Schicht zu Schicht und mit diesen Austritten gemäß einem vorgegebenen Schema sicherstellen, dadurch gekennzeichnet, daß die Zusammensetzung des dielektrischen Materials 92—98% Al$_2$O$_3$ und ein dielektrisches Schmelzmittel auf der Basis von Magnesiatitaniat umfaßt, dessen Zusammensetzung zwischen (TiO$_2$, 0,5 MgO) und (TiO$_2$, 6MgO) liegt, derart, daß die maximale Sintertemperatur auf einen Wert zwischen 1350 und 1450°C abgesenkt wird, wobei diese Zusammensetzung im wesentlichen frei von Siliziumoxyd, einer halogenhaltigen oder alkalihaltigen Verbindung und von kohlenstoffhaltigen Resten ist,

und daß die Leitungsmuster aus einem Metall, welches bei der maximalen im Laufe des Brennens erreichten Temperatur weder oxidierbar noch schmelzbar ist, oder einer Legierung solcher Metalle hergestellt ist.

2. Substrat nach Anspruch 1, dadurch gekennzeichnet, daß der Anteil von Al$_2$O$_3$ zwischen 95 und 97% liegt.

3. Substrat nach Anspruch 1, dadurch gekennzeichnet, daß die Zusammensetzung des Schmelzmittels (TiO$_2$, MgO) ist.

4. Substrat nach Anspruch 1, dadurch gekennzeichnet, daß die Leitungsmuster aus Palladium oder einer Silber-Palladiumlegierung hergestellt sind.

5. Substrat nach Anspruch 1, dadurch gekennzeichnet, daß die Verbindungen von Schicht zu Schicht und mit den Austritten mittels Durchgängen (41, 42) hergestellt sind, deren aufgebrachter Metallüberzug auf der Basis eines ebenfalls nicht oxidierbaren und bei einer hohen Temperatur nicht schmelzbaren Metalls oder einer Legierung solcher Metalle ist.

6. Substrat nach Anspruch 5, dadurch gekennzeichnet, daß der überzug der Durchgänge ausgehend von einer Metallisierungstinte, die mit Al$_2$O$_3$ beladen ist, hergestellt ist und die Leitungsmuster ausgehend von einer nicht mit Al$_2$O$_3$ beladenen Tinte hergestellt sind.

7. Substrat nach Anspruch 6, dadurch gekennzeichnet, daß die Zusammensetzung der mit Al$_2$O$_3$ beladenen Tinte 60—80% freies Metall und 2—5% Al$_2$O$_3$ in einem sich verflüchtigendem organischen Träger umfaßt.

8. Substrat nach Anspruch 7, dadurch gekennzeichnet, daß die Zusammensetzung der mit Al$_2$O$_3$ beladenen Tinte ein Schmelzmittel auf der Basis von Siliziumoxyd und von Magnesiumoxyd umfaßt, welches geeignet ist, die Brenntemperatur dieser Tinte auf einen Wert gleich der oder etwas tiefer als die Brenntemperatur des Aluminiumoxyds des Substrats abzusenken.

9. Substrat nach Anspruch 8, dadurch gekennzeichnet, daß die relativen Anteile des Schmelzmittels und des Al$_2$O$_3$ ungefähr (Al$_2$O$_3$, 4SiO$_2$, 3MgO) sind.

10. Substrat nach Anspruch 6, dadurch gekennzeichnet, daß die mit Al$_2$O$_3$ beladene Tinte ebenfalls für die Herstellung der Augen an der Mündung der Durchgänge verwendet wird.

11. Verfahren zur Herstellung eines Substrats nach einem der vorhergehenden Ansprüche, dadurch gekennzeichnet, daß es die Schritte umfaßt:

. Bohren von Löchern im ungesinterten Zustand mittels eines mit hoher Drehzahl angetriebenen Bohrers oder eines Stempel-Matrix-Systems,

. Füllen der Löcher mit einer mit Al$_2$O$_3$ beladenen Metallisierungstinte auf der Basis von Palladium oder einer Silber-Palladium-Legierung oder einem Tonerdehaltigem Keramikmaterial,

. Serigraphie der einzelnen Aluminiumoxydblätter mit Niederschlag einer anderen nicht mit Al$_2$O$_3$ beladenen Metallisierungstinte,

. Aufeinanderschichten der einzelnen Blätter,

. Agglomerieren des Blocks bei Wärme und unter Druck,

. Zusammensintern durch Brennen bei hoher Temperatur in oxydierender Atmosphäre und nach langsamem und programmiertem Entfernen der organischen Bindemittel.

12. Verfahren nach Anspruch 11, dadurch gekennzeichnet, daß man beim Schritt des Füllens der Löcher ebenfalls Augen an der Mündung dieser Löcher durch Serigraphie mit Aufbringen von mit Al$_2$O$_3$ beladener Metallisierungstinte sowie Leiter auf wenigstens einer der zwei Seiten des Substrats herstellt.

13. Verfahren nach Anspruch 11, dadurch gekennzeichnet, daß das Füllen der Löcher bei Ansaugen der Blätter auf einem Sockel und Dazwischenlegen einer porösen Papierschicht zwischen dem unteren Blatt und dem Sockel durchgeführt wird.

14. Verfahren nach Anspruch 11, dadurch gekennzeichnet, daß man darauf folgend einen Hybridschaltkreis auf wenigstens einer der zwei Seiten des Substrats aufbringt, welches mit seinen inneren Verbindungen und einzelnen, inneren Bauteilen hergestellt ist, wobei der Hybridschaltkreis mit der von der Schaltungsanordnung und den einzelnen, inneren Bauteilen gebildeten Gesamtheit mittels Stifte verbindet wird, die auf dem Substrat erscheinen.

**Claims**

1. Interconnecting substrate for electronic components, formed by a sintered stack of sheets of dielectric material (10) of which at least some bear conductive designs (21—24), the said substrate having conductive points of emergence (31, 32) to ensure the connection to the terminals of the component or components (1), with at least one internal layer provided with conductive tracks (24) which ensure the interconnection of layer to layer and with the points of emergence according to a predetermined plan, caracterised in that the composition of the dielectric material includes 92 to 98% Al$_2$O$_3$ and a dielectric melting agent based on magnesia titanate, the composition of which is between (TiO$_2$, 0.5 MgO) and (TiO$_2$, 6MgO), in such a way as to lower the maximum sintering temperature to a value between 1350 and 1450°C, this composition being substantially devoid of silica, halogenated or alkaline compounds and carbonaceous residues, and the conductive designs are made from a metal which, at the maximum temperature reached during the baking, is not oxidisable or fusible, or from an alloy of such metals.

2. Substrate as claimed in claim 1, characterised in that the proportion of Al$_2$O$_3$ is between 95 and 97%.

3. Substrate as claimed in claim 1, characterised in that the composition of the melting agent is (TiO$_2$, MgO).

4. Substrate as claimed in claim 1, characterised in that the conductive designs are made from palladium or a silver-palladium alloy.

5. Substrate as claimed in claim 1, characterised in that the interconnections of layer to layer and with the points of emergence are produced by means of through holes (41, 42) the metal lining of which is based on a metal which is also not oxidisable or fusible at high temperature or an alloy of such metals.

6. Substrate as claimed in claim 5, characterised in that the lining of the through holes is made from a metal-coating ink charged with Al$_2$O$_3$, the conductive designs being produced using an ink which is not charged with Al$_2$O$_3$.

7. Substrate as claimed in claim 6, characterised in that the composition of the ink charged with Al$_2$O$_3$ includes, in an organic evanescent medium, 60 to 80% of free metal and 2 to 5% Al$_2$O$_3$.

8. Substrate as claimed in claim 7, characterised in that the composition of the ink charged with Al$_2$O$_3$ includes a melting agent based on silica and magnesia capable of lowering the baking temperature of the said ink to a value equal to or slightly lower than the baking temperature of the alumina of the substrate.

9. Substrate as claimed in claim 8, characterised in that the relative proportions of the melting agent and the Al$_2$O$_3$ are approximately (Al$_2$O$_3$, 4SiO$_2$, 3MgO).

10. Substrate as claimed in claim 6, characterised in that the ink charged with Al$_2$O$_3$ is also used to produce flanges at the outlets of the through holes.

11. Method of manufacturing a substrate as claimed in one of the preceding claims, characterised in that it includes the following stages:

—boring of the holes before sintering, by a high-speed drill or by a punch-die system,

—filling the holes with a metal-coating ink based on palladium or a silver-palladium alloy charged with Al$_2$O$_3$, or an aluminous ceramic,

—screen printing of the individual sheets of alumina, with deposition of another metal-coating ink not charged with Al$_2$O$_3$,

—stacking of the individual sheets,

—agglomeration of the block under heat and pressure,

—sintering together by baking at high temperature in an oxidising atmosphere and after slow and programmed evacuation of the organic binders.

12. Method as claimed in claim 11, characterised in that, during the stage of filling the holes, the flanges at the outlets of these holes are also screen-printed, with deposition of the metal-coating ink charged with $Al_2O_3$, as well as the conductors on at least one of the two faces of the substrate.

13. Method as claimed in claim 11, characterised in that the holes are filled with the sheets held on a base by suction, a layer of porous paper being interposed between the lower sheet and the base.

14. Method as claimed in claim 11, characterised in that a hybrid circuit is then transferred to at least one of the two faces of the substrate produced with its internal connections and discrete internal components, this hybrid circuit being connected to the assembly formed by the circuitry and the discrete internal components through the intermediary of the contacts appearing on the substrate.

FIG.1

FIG.2

FIG.3

FIG.6

FIG.4

FIG.5